Europäisches Patentamt

European Patent Office

Office européen des brevets

(11) Publication number: **0 537 843 A1**

## EUROPEAN PATENT APPLICATION

(21) Application number: 92203095.2

(22) Date of filing: 08.10.92

(51) Int. Cl.5: **H01L 29/10**, H01L 29/167, H01L 29/36, H01L 29/70, H01L 29/86, H01L 29/90

(30) Priority: 16.10.91 GB 9121967

(43) Date of publication of application:
21.04.93 Bulletin 93/16

(84) Designated Contracting States:
DE FR GB IT NL

(71) Applicant: PHILIPS ELECTRONICS UK LIMITED
Philips House 1-19 Torrington Place
London WC1E 7HD(GB)

(84) GB

(71) Applicant: N.V. Philips' Gloeilampenfabrieken
Groenewoudseweg 1

NL-5621 BA Eindhoven(NL)

(84) DE FR IT NL

(72) Inventor: Huang, Eddie, c/o Philips Hazel
Grove
Bramhall Moor Lane, Hazel Grove
Stockport, Cheshire SK7 5BJ(GB)

(74) Representative: Clark, Jane Anne et al
PHILIPS ELECTRONICS Patents and Trade
Marks Department Philips House 1-19
Torrington Place
London WC1E 7HD (GB)

(54) **A two terminal semiconductor device.**

(57) The device (10b) has a semiconductor body (20) with a first region (1) of one conductivity type forming a first pn junction ($J_1$) with a lowly doped opposite conductivity type second region (2). A third region (3) of the one conductivity type forms a second pn junction ($J_2$) with the second region (2). The two terminals ($T_1$ and $T_2$) are arranged to apply a voltage across the device to forward-bias one and reverse bias the other of the pn junction ($J_1$ and $J_2$) to cause the device to breakover into conduction when the applied voltage exceeds a predetermined value. The second region (2) is doped with deep level impurities to a concentration at least equal to half that of the opposite conductivity type impurities. The deep level impurities compensate for the opposite conductivity type impurities to cause the depletion region of the reverse-biased pn junction ($J_1$ or $J_2$) to extend throughout the second region (2) to cause the device to conduct when the rate of change ($\frac{dv}{dt}$) with time of the applied voltage exceeds a predetermined level at a voltage below the predetermined voltage. Fourth and fifth regions (4 and 5) may be provided in and electrically shorted to the first and third regions (1 and 3), respectively, to provide a device having a triac-like on-state which, when connected in an AC circuit, will commutate-itself off at the next zero voltage crossing point.

FIG.3

This invention relates to a two terminal semiconductor device which may be used as a voltage transient suppressor, for example for inhibiting arcing of the contacts of a mechanical switch.

As used herein the term mechanical switch is intended to include any switch which performs its switching function by means of contacts which physically open or close together and includes switches such as magnetic or electromagnetic relays and motor commutator brushes. The mechanical switch has, in comparison to other forms of switch, the advantages of virtually zero on-state resistance and infinite blocking voltage but because of its relatively slow switching speed is only used where the on-off duty cycles are at least of the order of milliseconds and may for example be connected in mains power supply circuit.

A major disadvantage of the mechanical switch is the phenomenon of arcing. When the contacts open following conduction, a voltage appears across the contacts almost instantaneously. This voltage can be quite high (possibly higher than the peak of the mains voltage) and fast rising, depending on the inductiveness of the load and the stray inductances in the circuit. If the electric field generated by this voltage across the gap between the contacts at any instant is higher than the dielectric breakdown of air in the immediate environment an arc is produced. This results in gradual degradation of the switch and also has other undesirable consequences such as fire risks.

One known technique for suppressing such arcing in magnetic relays is to use a "triac-assisted relay" in which a conventional triac is connected across the relay contacts. By suitably controlling the gate drive signals to the triac in some sort of synchronism (with phase difference if necessary) with the relay it is possible to ensure that, at the moment the relay contacts open, current is diverted into the triac, which is then allowed to commutate back into the off-state after the contact gap has opened sufficiently to preclude any arcing. The relatively slow decrease in the on-state current through a triac during turn-off also eliminates any voltage spike that arises due to inductances in the circuit.

The disadvantage of this technique is the extra expense involved in having a synchronised drive circuit for the triac. Also it can only be used to suppress arcing in mechanical switches, such as relays, which are controlled electrically via a third terminal and cannot be used for ordinary mechanical switches or other such contacts.

Another known technique for suppressing arcing is to connect a bi-directional zener, a bi-directional breakover diode, or a diac, across the mechanical contacts. Any of these devices can be triggered into some kind of conducting state by a voltage equal to or higher than the avalanche or breakover voltage. By suitably choosing this voltage to be a little higher than the peak line voltage the device can suppress any over-voltage across the contacts that is higher than the breakover voltage and the peak line voltage (for example that generated by the contacts opening in a very inductive circuit), while maintaining the blocking capability of the switch up to the peak line voltage at other times. The advantage of this technique over the triac-assisted relay lies in this device being a two terminal device that is "self-triggered" by the phenomenon it seeks to suppress so that no extra gate drive circuits are needed, and the technique can be used across any mechanical contacts. The major disadvantage, though, is that it can only suppress voltage spikes higher than the peak line voltage, and it is well-known that voltages below this can induce arcing under certain conditions.

According to a first aspect of the present invention, there is provided a two terminal semiconductor device comprising a semiconductor body having a first region of one conductivity type forming a first pn junction with a second region which is relatively lowly doped with impurities of the opposite conductivity type and a third region of the one conductivity type spaced from the first region by the second region and forming a second pn junction with the second region, a first one of the two terminals being electrically connected to the first region and a second one of the two terminals being electrically connected to the third region for applying a voltage across the series arrangement of the first, second and third regions to forward-bias one and reverse-bias the other of the first and second pn junctions to cause the device to breakover into conduction when the applied voltage exceeds a predetermined level, the second region being doped with deep level impurities of the one conductivity type to a concentration at least equal to half the concentration of opposite conductivity type impurities in the second region which deep level impurities compensate for the impurities of the opposite conductivity type to cause the depletion region associated with the reverse-biassed one of the first and second pn junctions to extend throughout the second region to cause the device to conduct when the rate of change $\frac{dv}{dt}$ with time of the voltage applied across the series arrangement exceeds a predetermined level at a voltage below the predetermined voltage.

A two terminal semiconductor device in accordance with the invention is thus a bi-directional self-triggered device which has a breakover voltage which is arranged to be higher than the normal peak voltage applied across the terminals, for example the normal peak transmission line voltage where the device is intended to suppress transmission line surges or transients, so that the device can withstand or block voltages below the breakover voltage but is also capable of being triggered into conduction by a fast rising voltage pulse even where the voltage pulse peak voltage is below the breakover voltage of the device. Such a device may be provided across the movable contacts of a mechanical switch in an electrical circuit to inhibit arcing across the contacts when the switch is operated to open the contacts.

A device in accordance with the invention is self-triggered in that triggering of conduction is not dependent on a signal applied to a gate terminal but is initiated by the voltage across the two terminals. A device in accordance with the invention can thus be used with any mechanical contacts and does not require a separate gate drive circuit.

A fourth region of the opposite conductivity type may be provided within the first region and a fifth region of the opposite conductivity type may be provided within the third region, the first and second terminals electrically shorting the fourth region to the first region and the fifth region to the third region, respectively, to provide two gateless thyristor structures arranged in anti-parallel with one another. The third and fourth regions are laterally spaced, so as to have no or only a very small overlap. Such a device may have a triac-like on-state characteristic and accordingly when connected in an AC circuit will commutate itself off at the next zero voltage crossing point.

In a second aspect, the present invention provides a two terminal semiconductor device comprising first and second semiconductor bodies each having a first region of one conductivity type forming a first pn junction with a second region which is relatively lowly doped with impurities of the opposite conductivity type and a third region of the one conductivity type spaced from the first region by the second region and forming a second pn junction with the second region, a fourth region of the opposite conductivity type being provided within the first region of the first semiconductor body and a fifth region of the opposite conductivity type being provided within the third region of the second semiconductor body, a first one of the two terminals electrically connecting the first regions of the two semiconductor bodies and electrically shorting the fourth region to the first region of the first semiconductor body and a second one of the two terminals electrically connecting the third regions of the two semiconductor bodies and electrically shorting the fifth region to the third region of the second semiconductor body to provide two gateless thyristor structures arranged in antiparallel with one another and to enable a voltage to be applied across the series arrangement of the first, second and third regions to forward-bias one and reverse-bias the other of the first and second pn junctions to cause the device to breakover into conduction when the applied voltage exceeds a predetermined level, the second region being doped with deep level impurities of the one conductivity type to a concentration at least equal to half the concentration of opposite conductivity type impurities in the second region which deep level impurities compensate for the impurities of the opposite conductivity type to cause the depletion region associated with the reverse-biassed one of the first and second pn junctions to extend throughout the second region to cause the device to conduct when the rate of change $\frac{dv}{dt}$ with time of the voltage applied across the series arrangement exceeds a predetermined level at a voltage below the predetermined voltage.

In such a device again two gateless thyristor structures are provided; however, in this example, the two gateless thyristor structures are provided in separate semiconductor bodies and are electrically connected in antiparallel by the terminal connections.

The or each second region may be doped with impurities of the opposite conductivity type to a dopant concentration of from about $10^{14}$ atoms cm$^{-3}$ to about $10^{15}$ atoms cm$^{-3}$. Typically, the opposite conductivity type may be n conductivity type and the deep level impurities may provide deep level acceptors. Where the or each second region comprises a silicon region the deep level impurities may be provided by gold atoms.

It should be noted that JP-A-1-125873 describes a different type of voltage surge suppression semiconductor device in which the surge suppression is formed by a low voltage zener diode. A low voltage zener diode has a narrow depletion region and thus a high capacitance which leads to power loss in high frequency transmission lines. Accordingly, in JP-A-1-125873 two additional diode elements are provided in series with the zener diode to reduce its capacitance. These additional diodes are formed with a very thin n-conductivity type region between the more highly doped p+ and n+ conductivity regions and so have a lower capacitance than the zener diode. The capacitance can be further reduced by doping the very thin n-conductivity type region with gold atoms. When connected in series with the zener diode, these two additional diodes cause the capacitance seen by the transmission lines to be much smaller because, when several capacitances are connected in series, the smallest dominates.

Embodiments of the invention will now be described, by way of example, with reference to the accompanying drawings, in which:

Figure 1 is a simplified diagram of an AC mains circuit in which a two-terminal semiconductor device in accordance with the invention is connected across a mechanical switch;

Figure 2 is a cross-sectional view of a first embodiment of a two terminal semiconductor device in accordance with the invention;

Figure 3 is a cross-sectional view of a second embodiment of a two terminal semiconductor device in accordance with the invention and

Figure 4 is a cross-sectional view of a modified version of the second embodiment in which the semiconductor device is formed by two connected discrete semiconductor bodies.

It should be understood that the Figures are merely schematic and are not drawn to scale. In particular certain dimensions such as the thickness of layers or regions may have been exaggerated whilst other dimensions may have been reduced. It should also be understood that the same reference numerals are used throughout the Figures to indicate the same or similar parts.

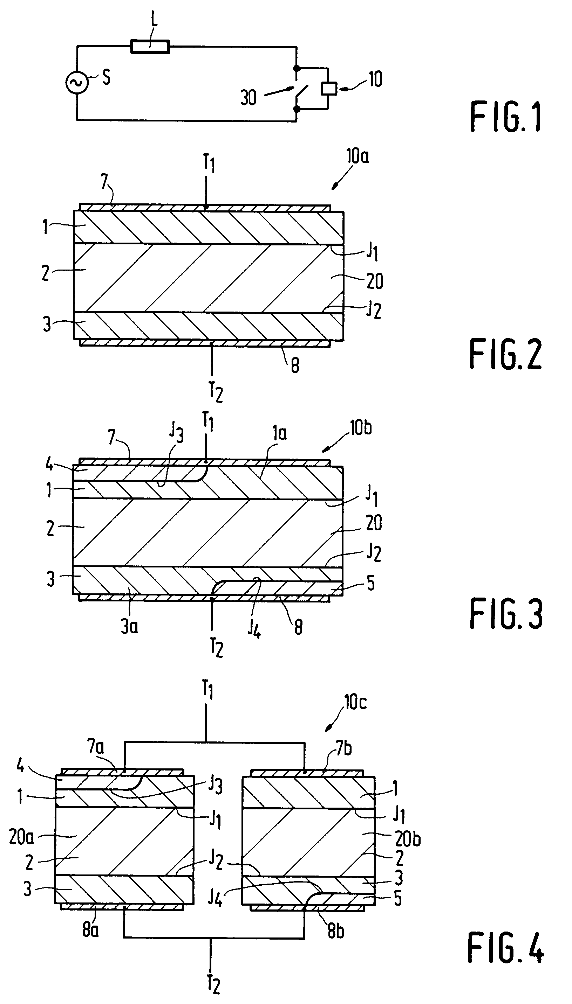

Figure 1 illustrates in a very schematic and simplified manner a typical application for a two terminal semiconductor device 10 in accordance with the invention.

In the application shown in Figure 1, the two terminal semiconductor device 10 is connected across a mechanical switch 30 which controls the connection of a load L to a power supply in the example illustrated an AC power supply S typically a mains AC supply having a frequency of 50 or 60 Hz (Hertz). The load L is shown simply as a resistor but typically may comprise resistive, inductive, and/or capacitive components. The two terminal semiconductor device 10 acts, as will be described below,to suppress voltage transients which may arise on operation of the mechanical switch 30 and so to inhibit arcing between the contacts of the mechanical switch 30.

Figures 2 to 4 illustrate various examples of two terminal semiconductor devices 10 in accordance with the invention which may be used in, for example, the circuit of Figure 1.

The two terminal semiconductor device 10a shown in Figure 2 comprises a semiconductor body 20 having a first region 1 of one conductivity type, p conductivity type in this example, forming a first pn junction $J_1$ with a second region 2 which is relatively lowly doped with impurities of the opposite conductivity type, n conductivity type in this example, and a third region 3 of the one conductivity type spaced from the first region 1 by the second region 2 and forming a second pn junction $J_2$ with the second region 2.

A first one $T_1$ of the two terminals is electrically connected to the first region 1 and a second one $T_2$ of the two terminals is electrically connected to the third region 3 for applying a voltage across the series arrangement of the first, second and third regions 1,2 and 3 to forward-bias one and reverse bias the other of the first and second pn junctions $J_1$ and $J_2$ to cause the device to breakover into conduction when the applied voltage exceeds a predetermined value.

The second region 2 is doped with deep level impurities of the one conductivity type to a concentration at least equal to half the concentration of opposite conductivity type impurities in the second region 2. The deep level impurities compensate for the impurities of the opposite conductivity type to cause the depletion region associated with the reverse-biased one of the first and second pn junctions $J_1$ and $J_2$ to extend throughout the second region 2 so as to join together the first and third regions 1 and 3 to cause the device to conduct when the rate of change $\frac{dv}{dt}$ with time of the voltage applied across the series arrangement exceeds a predetermined levelat a voltage below the predetermined voltage.

A first current-carrying electrode 7 is in ohmic contact with the first region 1 to connect the same to the first terminal $T_1$ while a second current-carrying electrode 8 is in ohmic contact with the third region 3 to connect the third region 3 to the second terminal $T_2$.

Typically the semiconductor body 20 comprises a monocrystalline silicon body in which the various regions are formed in conventional manner by the introduction of dopant impurities. Although the first and third regions 1 and 3 are shown as extending completely across the second region 2 so as to provide flat pn junctions $J_1$ and $J_2$, the first and third regions 1 and 3 could, by the use of appropriate masks, be formed as planar regions. In the arrangement shown, one or more of the first, second and third regions 1 to 3 could be formed as an epitaxially deposited layer.

The dopant concentration within the second region 2 is moderate to low, typically $10^{14}$ to $10^{15}$ atoms $cm^{-3}$, for example $2 \times 10^{14}$ atoms $cm^{-3}$, and its width or thickness is such that, in conjunction with the chosen doping, the first and second pn junctions $J_1$ and $J_2$ are each able to withstand the required voltages which may be between, for example, 50 to 2000 V (volts). Typically the second region 2 may have a width of between 50 and 500$\mu$m. The first and third regions 1 and 3 will of course have a dopant concentration much higher than that of the second region 2 and may have any suitable desired width or thickness. The second region 2 is doped with deep level impurities, in this example gold atoms, to a concentration comparable, that is at least equal to half, the donor impurity doping level within the second region 2. Although gold atoms are in this example diffused into the second region to provide the deep level acceptor impurities, any other species that forms an acceptor state relatively deep in the band gap of the semiconductor material, in this example silicon, may be used. The use of gold is however particularly suitable for the application described with reference to Figure 1 because the emission time of electrons from the deep level provided by gold atoms in silicon is of the order of 1ms (millisecond) at room temperature making gold a suitable deep level impurity for use in devices to be incorporated in AC mains circuits.

When the two terminal semiconductor device 10a shown in Figure 2 is connected across the contacts of the mechanical switch 30 as shown in Figure 1, the voltage across the terminals $T_1$ and $T_2$ will be virtually zero while the switch is in the closed condition and no appreciable current will flow through the device 10a. In this situation the majority of the second region 2 will be in a 'neutral' state in which most of the donor atoms are ionised having given up their electrons and become positively charged so that the total ionised charge level will be approximately equal to the donor doping level $N_D$. The electrons freed by the donor atoms would normally reside in the conduction band. However the presence of a significant level of deep level impurities (comparable to the donor doping level) results in many of the electrons being captured by the acceptor sites provided by the deep level impurities so that the deep level impurities 'compensate' for the donor doping. the compensation is such that the net ionised charge level in the bandgap will be approximately $N_D - N_A$, where $N_A$ is the acceptor doping level, provided $N_A$ is equal to or lower than $N_D$. If $N_A$ is greater than $N_D$ the net charge level does not become negative (that is the zone is not compensated to become P-type), but merely close to zero (that is the zone becomes effectively intrinsic), by virtue of the fact that the acceptor level is a deep state, that is while it can accept an electron from the conduction band it does not normally do so from the valence band. In summary, the effective doping is significantly lower than $N_D$, possibly close to intrinsic.

When the contents of the mechanical switch 30 open, a voltage suddenly appears across them and is established across the terminals $T_1$ and $T_2$ of the device 10a. A depletion layer will be established across the one of the two pn junctions $J_1$ and $J_2$ which is reverse-biassed by this voltage. Thus, if the terminal $T_1$ is negative with respect to the terminal $T_2$ a depletion layer will be established across the pn junction $J_1$. The extent or width of this depletion region is determined by the magnitude of the voltage applied across the terminals $T_1$ and $T_2$ and the ionised charge density within the band gap of the semiconductor forming the second region 2. Initially this charge density will be roughly equal to $N_D - N_A$ (where $N_A < N_D$) or close to zero (where $N_A > N_D$), as explained above. The depletion layer will therefore spread significantly further than if the acceptors were not present. For deep acceptor states as described, the likelihood of their being ionised to reduce the net charge density in the band gap by compensation depends on there being a finite density of electrons in the conduction band. When a depletion layer is formed, sweeping out most of the conduction electrons, the deep level acceptors will start to emit their captured electrons into the conduction band, and these are then also swept out. Eventually the net ionised charge density in the band gap will return to a value close to that due to the donor doping $N_D$ alone. If, however, the voltage applied across the terminals $T_1$ and $T_2$ rises significantly faster than the emission time of electrons from these acceptor states, then the depletion layer sees a net charge density in the band gap much lower than $N_D$ because of the compensation effect, and the depletion layer will spread until it extends from the first region 1 to the third region 3 so as to join the first and third regions 1 and 3 together, at which stage punch-through occurs enabling a hole current to flow between the first and third region 1 and 3. Such punch-through will occur even when the applied voltage is relatively low, for example 50 volts, if the voltage is increasing rapidly, that is, typically, if the voltage is increasing at a rate greater than about 5V/$\mu$s (volts per microsecond).

The voltage across the device 10a shown in Figure 2 may continue to increase ohmically with increasing current beyond the voltage at which punch-through occurs and, with a suitable choice of device structure, the device 10a will not stabilise in the conducting state but will return to its blocking state once the acceptors become de-ionised in the depletion layer by which time the mechanical contacts will have opened sufficiently to make the possibility of arcing remote. The total conducting time of the device 10a is governed by the de-ionisation rate of the deep level acceptors and is not influenced by the cycle time of the AC mains. Such a device may therefore also be useful in DC circuits, for example across the commutator brushes in a DC (direct current) motor. If the voltage across the terminals $T_1$ and $T_2$ only rises slowly then the depletion region will not spread sufficiently to cause punch-through by the effect mentioned above. However, if the voltage exceeds a predetermined value then avalanche breakdown of the reverse-biassed one of the first and second pn junctions $J_1$ and $J_2$ will occur resulting in conduction through the device.

Figure 3 illustrates another embodiment of a two terminal semiconductor device in accordance with the invention.

The device 10b shown in Figure 3 is similar to that shown in Figure 2 except that it includes two additional regions. Thus, a fourth region 4 of the opposite conductivity type, n conductivity type in this case, is provided as a planar region within the first region 1 so as to form a third pn junction $J_3$ with the first region 1. A fifth region 5 is similarly provided within the third region 3 to form a fourth pn junction $J_4$ with the third region 3. The electrodes 7 and 8, as shown in Figure 3, contact the first and fourth regions 1 and 4 and third and fourth regions 3 and 5 respectively so as to short parts of the pn junctions $J_3$ and $J_4$. The fourth and fifth regions 4 and 5 are laterally spaced so that there is no, or only a small, overlap between the fourth and fifth regions 4 and 5 so that the device will commutate itself off at the zero-crossing point. Thus, a major part of the fourth region 4 is opposed to part 3a of the third region 3 which does not contain the fifth region 5 and a major part of the fifth region 5 is opposed to a part 1a of the first region 1 which does not contain the fourth region 4. The device 10b thus has two gateless thyristor structures arranged in antiparallel relationship to one another.

The second region 2 has a similar doping concentration and thickness to that given above in relation to Figure 2 and has a deep level acceptor dopant concentration, again generally gold, comparable to the donor doping concentration.

Figure 4 illustrates a modified version 10c of the device 10b shown in Figure 3 in which the device is composed of two discrete semiconductor bodies 20a and 20b each of which provides a structure which is blocking in one direction and conducting in the other. For comparison purposes similar reference numerals have been used in Figure 4. Thus in Figure 4 each of the thyristor structures is provided in a respective semiconductor body 20a, 20b and the two electrodes are each divided into two parts 7a, 7b and 8a,8b which are connected together by means of respective bonding wires to their respective terminals $T_1$ and $T_2$. The device 10c functions in the same manner as the integrated device 10b of Figure 3 and accordingly only the operation of the device 10b will be described.

As in the case of the device 10a, when the two terminal semiconductor device 10b or 10c shown in Figure 3 or 4 is connected across the contacts of the mechanical switch 30 as shown in Figure 1 the voltage across the terminals $T_1$ and $T_2$ will be virtually zero while the switch is in the closed condition and no appreciable current will flow through the device 10b or 10c.

When the contacts of the mechanical switch 30 open, a voltage suddenly appears across them and is established across the terminals $T_1$ and $T_2$ of the device 10b or 10c. A depletion layer will be established across the one of the two pn junction $J_1$ and $J_2$ which is reverse-biassed by this voltage. Thus, if the terminal $T_1$ is at a negative voltage with respect to the terminal $T_2$ a depletion layer will be established across the pn junction $J_1$. As indicated above, the extent or width of this depletion region is determined by the magnitude of the voltage applied across the terminals $T_1$ and $T_2$ and the ionised charge density within the band gap of the semiconductor forming the second region 2. If the voltage applied across the terminals $T_1$ and $T_2$ rises significantly faster than the emission time of electrons from these acceptor states, then the depletion layer sees a net charge density in the band gap much lower than $N_D$ because of the compensation effect, and the depletion layer will spread until it extends from the first region 1 to the third region 3 so joining together the first and third regions 1 and 3, at which stage punch-through occurs enabling a hole current to flow between the first and third regions 1 and 3. This has the effect of forward biassing the third junction $J_3$ causing the fourth region 4 to inject electrons into the first region 1, ultimately turning on the four layer thyristor structure formed by regions 3,2,1 and 4. The device 10b or 10c thus goes into a low impedance on-state and limits the voltage rise across the terminals $T_1$ and $T_2$ required to cause punch-through between the first and third regions 1 and 3. The turning on of the device in this manner requires a rapidly rising voltage to be present across the terminals $T_1$ and $T_2$ so that the thyristor structure 3,2,1,4 (the other thyristor 1,2,3,5 if the polarity of the applied voltage is reversed) turns on before the deep level acceptors can emit their captured electrons. Once the thyristor has been turned on, conduction will not be affected by the acceptors then becoming de-ionised. Thus the voltage transient across the contacts of the mechanical switch 30 is limited to that required to cause punch-through under these conditions.

If, as in the case of Figure 1, the circuit is an AC-mains circuit, the device 10b or 10c will commutate itself off at the next zero crossing point. The voltage rise at turn-off will not then cause an arc to form. Once into the blocking state, the rate of rise in voltage in the normal AC-sine wave will be slower than the emission rate of electrons from acceptors in the depletion layer. Thus in the "normal" blocking situation the depletion layer will only spread a width into the region 2 determined largely by $N_D$, and with suitable choice this can be made to be well short of punch-through, and no turn-on will result. Thus such a device is capable of blocking the normal mains voltage, but also successfully prevents arcing across a mechanical switch when a fast-rising voltage appears at the contacts being opened, at the expense of a very small and insignificant extra part-cycle (maximum 10 ms for 50 Hz mains) of conduction.

Again if the voltage across the terminals $T_1$ and $T_2$ rises only slowly but exceeds the predetermined value the reverse-biassed one of the junctions $J_1$ and $J_2$ will breakdown, again ultimately rendering one of the thyristors conducting.

It will of course be appreciated that while the above description refers to the case where the terminal $T_1$ is negative with respect to $T_2$, because in each of the examples given above the device structure is symmetric, similar reasoning will apply when a voltage of the reverse polarity is applied across the terminals $T_1$ and $T_2$.

The present invention thus provides a two terminal semiconductor device with blocking and conducting states in both directions (or two separate devices connected in antiparallel, each with blocking and conducting states in one direction only), which may be used as a transient voltage suppressor, in particular to prevent or reduce arcing across mechanical switch contacts.

A device in accordance with the invention has a breakover or avalanche voltage sufficiently high to withstand the normal operating voltages of the circuit in which it is connected while at the same time protecting the circuit against overvoltage and in addition being capable of being triggered into conduction by a fast rising voltage pulse such as may occur upon the opening of the contacts of a mechanical switch.

When connected across the contacts of a mechanical switch, as schematically shown in Figure 1, a device in accordance with the invention has the ability to prevent or reduce arcing when the contacts open. This relies on the fact that when the contacts open in a mains circuit, the current is interrupted suddenly and the voltage that appears across the switch invariably rises very sharply (whether the circuit is inductive or not). This fast rising voltage pulse gives a dV/dt that triggers the device into the on-state so that no high field will appear across the contacts to cause arcing.

Although the above examples have used gold doping to provide the deep level acceptors, other acceptor dopants may be used; the different depths of these other acceptor states in the band gap may give different de-ionisation times and therefore make them suitable for different circuit requirements.

It will of course be appreciated that the conductivity types given above could be reversed and that the present invention may be applied to semiconductor materials other than silicon, for example germanium or compound semiconductors such as silicon-germanium or III-V semiconductor materials.

From reading the present disclosure, other modifications and variations will be apparent to persons skilled in the art. Such modifications and variations may involve other features which are already known in the semiconductor art and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

**Claims**

1.  A two terminal semiconductor device comprising a semiconductor body having a first region of one conductivity type forming a first pn junction with a second region which is relatively lowly doped with impurities of the opposite conductivity type and a third region of the one conductivity type spaced from the first region by the second region and forming a second pn junction with the second region, a first one of the two terminals being electrically connected to the first region and a second one of the two terminals being electrically connected to the third region for applying a voltage across the series arrangement of the first, second and third regions to forward-bias one and reverse-bias the other of the first and second pn junctions to cause the device to breakover into conduction when the applied voltage exceeds a predetermined level, the second region being doped with deep level impurities of the one conductivity type to a concentration at least equal to half the concentration of opposite conductivity type impurities in the second region which deep level impurities compensate for the impurities of the opposite conductivity type to cause the depletion region associated with the reverse-biassed one of the first and second pn junctions to extend throughout the second region to cause the device to conduct when the rate of change $\frac{dv}{dt}$ with time of the voltage applied across the series arrangement exceeds a predetermined level at a voltage below the predetermined voltage.

2. A device according to Claim 1, wherein a fourth region of the opposite conductivity type is provided within the first region and a fifth region of the opposite conductivity type is provided within the third region laterally spaced from the first region to provide two gateless thyristor structures arranged in antiparallel with one another, the first and second terminals electrically shorting the fourth region to the first region and the fifth region to the third region, respectively.

3. A two terminal semiconductor device comprising first and second semiconductor bodies each having a first region of one conductivity type forming a first pn junction with a second region which is relatively lowly doped with impurities of the opposite conductivity type and a third region of the one conductivity type spaced from the first region by the second region and forming a second pn junction with the second region, a fourth region of the opposite conductivity type being provided within the first region of the first semiconductor body and a fifth region of the opposite conductivity type being provided within the third region of the second semiconductor body, a first one of the two terminals electrically connecting the first regions of the two semiconductor bodies and electrically shorting the fourth region to the first region of the first semiconductor body and a second one of the two terminals electrically connecting the third regions of the two semiconductor bodies and electrically shorting the fifth region to the third region of the second semiconductor body to provide two gateless thyristor structures arranged in antiparallel with one another and to enable a voltage to be applied across the series arrangement of the first, second and third regions to forward-bias one and reverse-bias the other of the first and second pn junctions to cause the device to breakover into conduction when the applied voltage exceeds a predetermined level, the second region being doped with deep level impurities of the one conductivity type to a concentration at least equal to half the concentration of opposite conductivity type impurities in the second region which deep level impurities compensate for the impurities of the opposite conductivity type to cause the depletion region associated with the reverse-biassed one of the first and second pn junctions to extend throughout the second region to cause the device to conduct when the rate of change $\frac{dv}{dt}$ with time of the voltage applied across the series arrangement exceeds a predetermined level at a voltage below the predetermined voltage.

4. A device according to any one of the preceding claims, wherein the or each second region is doped with impurities of the opposite conductiviy type to a dopant concentration of from about $10^{14}$ atoms $cm^{-3}$ to about $10^{15}$ atoms $cm^{-3}$.

5. A device according to any one of the preceding claims, wherein the opposite conductivity type is n conductivity type and the deep level impurities provide deep level acceptors.

6. A device according to claim 5, wherein the or each second region comprises a silicon region and the deep level impurities are provided by gold atoms.

7. A two terminal semiconductor device substantially as hereinbefore described with reference to the accompanying drawings.

8. Use of a device in accordance with any one of the preceding claims across the movable contacts of a switch in an electrical circuit for inhibiting arcing across the contacts when the switch is operated to open the contacts.

FIG.1

FIG.2

FIG.3

FIG.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | GB-A-1 447 763 (WESTINGHOUSE BRAKE AND SIGNAL COMPANY LTD) * the whole document * | 1-8 | H01L29/10 H01L29/167 H01L29/36 H01L29/70 |
| A | DE-A-3 151 212 (MITSUBISHI DENKI K.K.) * page 6, line 6 - line 11; figures * | 1-8 | H01L29/86 H01L29/90 |
| A | EP-A-0 361 320 (ASEA BROWN BOVERI) * column 4, paragraph 3; figures * | 1-8 | |
| A | US-A-4 066 484 (GENERAL ELECTRIC COMP) * abstract; figures * | 1-8 | |
| A | EP-A-0 194 936 (THOMSON-CSF) * abstract; figures * | 1-8 | |

-----

**TECHNICAL FIELDS SEARCHED (Int. Cl.5)**

H01L

The present search report has been drawn up for all claims

| Place of search | Date of completion of the search | Examiner |
|---|---|---|
| THE HAGUE | 24 NOVEMBER 1992 | SINEMUS M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)